# EUROPEAN PATENT APPLICATION

(11) **EP 2 315 195 A1**
(43) Date of publication of application: **27.04.2011**
(21) Application number: 09808136.7
(22) Date of filing: 23.06.2009
(51) Int. Cl.: G09F 9/00, G02F 1/1333, H05K 1/02, H05K 7/14

(54) **ELECTRONIC PACKAGE, DISPLAY DEVICE AND ELECTRONIC APPARATUS**

(30) Priority: 22.08.2008 JP 2008213501
(71) Applicant: Sharp Kabushiki Kaisha, Osaka-shi, Osaka 545-8522 (JP)
(72) Inventor: YOKONUMA, Shinsuke, OSAKA 545-8522 (JP)
(74) Representative: Müller-Boré & Partner Patentanwälte
(86) International application number: PCT/JP2009/061372
(87) International publication number: WO 2010/021200

(57) **Abstract**

Provided is an electronic package wherein a built-in chassis (CS) and an FPC substrate (11) including a ground pattern (12) are mounted on a front bezel (BZ1) and a back bezel (BZ2) formed of a conductive material. A ground pattern (12) is arranged between the back bezel (BZ2) and the built-in chassis (CS), and the back bezel (BZ2) includes a claw section (22) for pressing the ground pattern (12) to the built-in chassis (CS). The claw section (22) has elasticity when the claw section is in a linear state, and presses the ground pattern (12) by a leading end (22T) formed by bending an outer periphery.

## Description

### Technical Field

The present invention relates to an electronic package, a display device and an electronic apparatus.

### Background Art

Conventionally, in various electronic apparatuses, measures against static electricity are taken. For example, in a liquid crystal display device (display device) 169 as well that is described in a patent document 1 and shown in a perspective view of Fig. 7, measures against static electricity are taken.

In detail, the liquid crystal display device 169 described in the patent document 1, a liquid crystal display panel 159 is sandwiched between an upper metal housing bz1 and a lower metal housing bz2. Besides, in the liquid crystal display panel 159, an FPC (Flexible Printed Circuits) board 111 that connects a driver (not shown) for driving the liquid crystal and a main board (not shown) to each other is disposed (here, a thing in which the FPC board 111 is disposed in at least one of the metal housings bz1, bz2 is also called an electronic package pg).

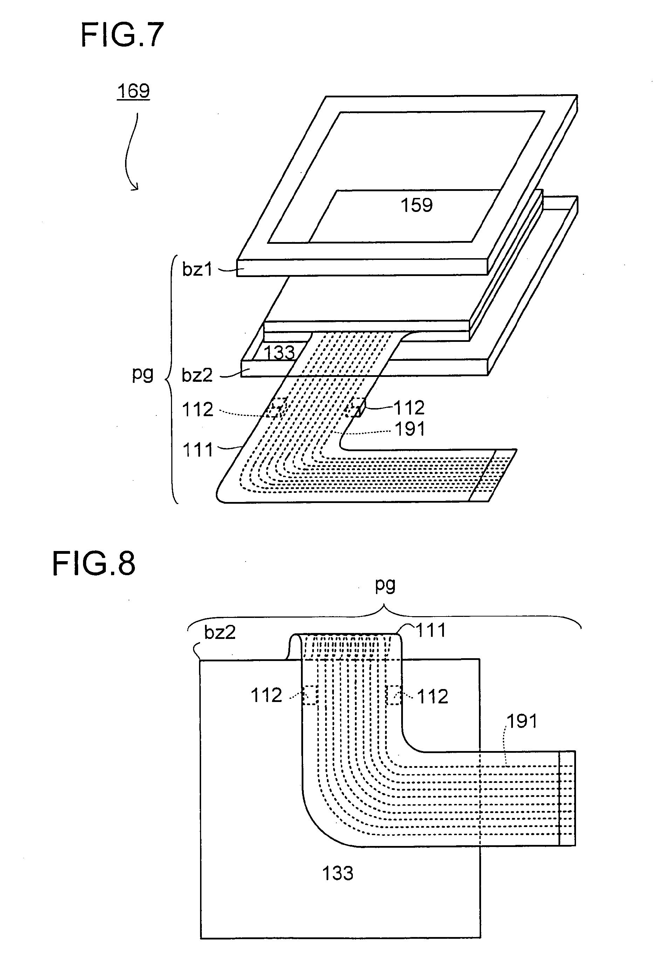

The FPC board 111, as shown in a plan view of Fig. 8, hangs down to cover a side surface of the lower metal housing bz2 and bends to cover a rear side of a bottom surface 133 of the lower metal housing bz2. And, on part of the FPC board 111 that covers the rear side of the bottom surface 133 of the lower metal housing bz2, a ground pattern 112 is formed (here, a ground line 191 contained in the FPC board 111 is connected to the ground pattern 112). As a result of this, the ground pattern 112 touches the lower metal housing bz2 that has electrical conductivity.

According to this, even if static electricity occurs in the liquid crystal display device 169, the static electricity flows to the lower metal housing bz2 via the ground pattern 112. Accordingly, for example, malfunction of various circuits of the liquid crystal display device 169 due to the static electricity do not happen.

### Citation List

### Patent Literature

PLT1: JP-A-2006-350243

### Summary of Invention

### Technical Problem

However, in the liquid crystal display device 169, the ground pattern 112 and the lower metal housing bz2 are connected to each other via an electro-conductive adhesive (see paragraph [0024] in the patent document 1). Because of this, the cost of the liquid crystal display device 169 inevitably becomes high.

Besides, in light of cost reduction, it is conceivable to directly connect the ground pattern 112 and the lower metal housing bz2 to each other without using the electro-conductive adhesive. However, the ground pattern 112 is disposed in the FPC board 111 that flexibility. Because of this, if the FPC board 111 bends and the ground pattern 112 deviates, the ground pattern 112 and the lower meal housing bz2 are likely to peel off each other (in short, static electricity is unlikely to escape to the lower metal housing bz2).

The present invention has been made to solve the above problems. And, it is an object to provide an electronic package and the like that surely perform contact between a ground pattern and a member that serves as a conductive portion.

### Solution to Problem

In the electronic package, a chassis and a circuit board including a ground pattern are disposed in a housing. In the electronic package, the ground pattern is present between the housing and the chassis. And, the housing includes a push piece that pushes the ground pattern against the chassis; and the push piece has elasticity in a linear state and pushes the ground pattern by means of a tip end whose outer edge is rounded.

According to this, the ground pattern is sandwiched between the two members (housing and chassis), so that the ground pattern is unlikely to deviate excessively considerably. Moreover, the push piece is formed at one end of the housing; and the push piece, thanks to elasticity of itself, relatively firmly pushes the ground pattern against the chassis. Because of this, without using a separate member like an electro-conductive adhesive, the ground pattern and the housing touch each other and static electricity flows to the housing.

Besides, the rounded tip end of the push piece touches the ground pattern, so that a sharp member does not touch the ground pattern. Accordingly, the ground pattern is unlikely to be broken.

Here, the shape of the push piece is not limited to a thing that is a linear piece having elasticity and has a tip end whose outer edge is rounded. For example, the push piece may swell from a surface of the housing and a tip end of the swelling may be formed into a curved surface. And, such a push piece may push the ground pattern by means of the curved-surface tip end.

Even according to this, the curved-surface tip end of the push piece touches the ground pattern, so that a sharp member does not touch the ground pattern. Accordingly, the ground pattern is unlikely to be broken.

Here, it is possible to say that a display device incorporating such an electronic package and an electronic apparatus incorporating the display device are the present invention.

### Advantageous Effects of Invention

According to the present invention, the contact between the ground pattern and the housing that serves as the conductive portion is surely performed; and static electricity flows to the housing. Accordingly, various disadvantages (e.g., circuit malfunction) due to the static electricity do not happen.

### Brief Description of Drawings

[Fig. 1] is a sectional view taken along and viewed from an arrow A-A' line of a liquid crystal display device shown in Fig. 2.
[Fig. 2] is an exploded perspective view of a liquid crystal display device.
[Fig. 3A] is a plan view showing a bottom surface of a rear bezel.
[Fig. 3B] is a sectional view taken along and viewed from an arrow B-B' line of the rear bezel shown in Fig. 3A.
[Fig. 3C] is a perspective view showing a bottom surface of a rear bezel.
[Fig. 4] is a sectional view taken along and viewed from an arrow C-C' line of a liquid crystal display device shown in Fig. 5.
[Fig. 5] shows an exploded perspective view of a liquid crystal display device different from Fig. 2.
[Fig. 6A] is a plan view showing a bottom surface of a rear bezel different from Fig. 3A.
[Fig. 6B] is a sectional view taken along and viewed from an arrow D-D' line of the rear bezel shown in Fig. 6A.
[Fig. 6C] is a perspective view showing a bottom surface of a rear bezel different from Fig. 3C.
[Fig. 7] is an exploded perspective view of a conventional liquid crystal display device.
[Fig. 8] is a plan view showing an FPC board and a lower metal board that are connected to a liquid crystal display panel shown in Fig. 7.

### Description of Embodiments

### [Embodiment 1]

An embodiment is described based on drawings as follows. Here, for convenience, hatching, member numbers and the like are omitted in some cases; in this case, other drawings are referred to. Besides, a black dot in a drawing means a direction perpendicular to a paper surface.

Here, in the following description, as an example of a display device, a liquid crystal display device is described; however, this is not limiting. For example, an organic EL (Electro-Luminescence) display and a plasma display may be used.

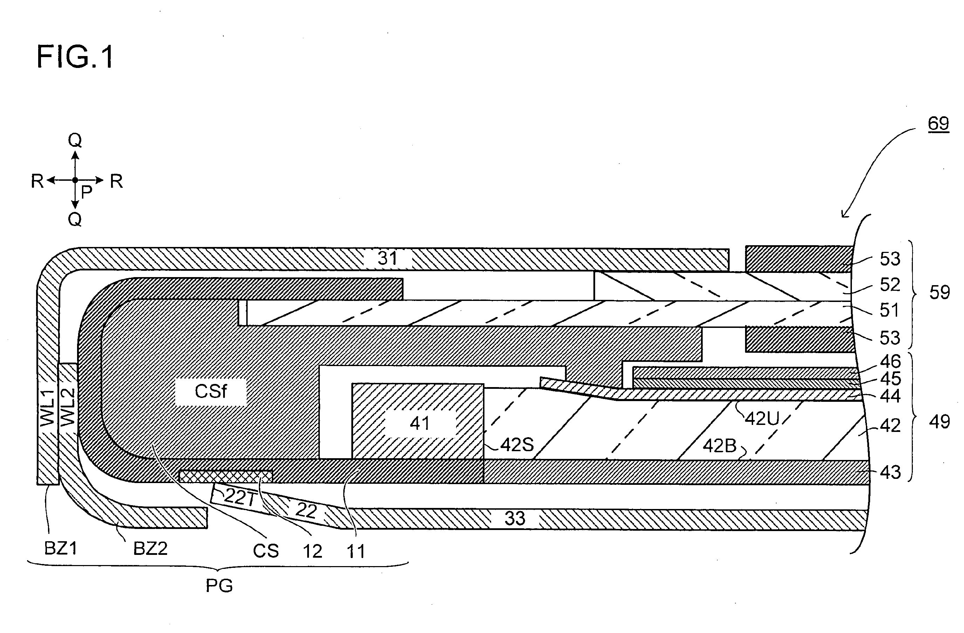

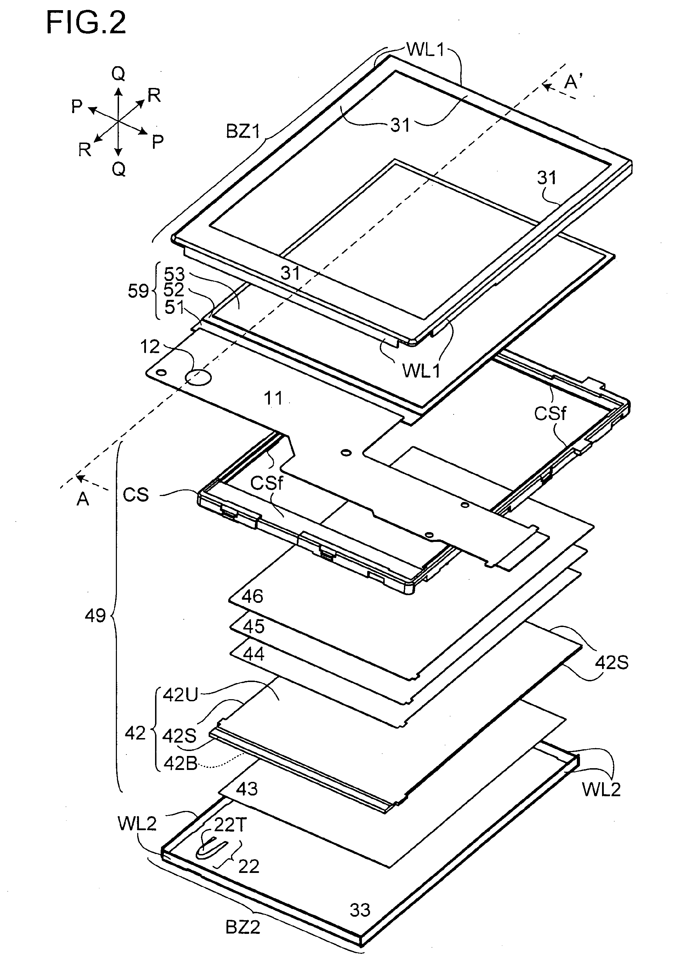

A sectional view of Fig. 1 and an exploded perspective view of Fig. 2 show a liquid crystal display device 69 (here, the sectional direction in Fig. 1 is a direction taken along and viewed from an arrow A-A' line in Fig. 2.)

As shown in Fig. 1 and Fig. 2, the liquid crystal display device 69 includes: a liquid crystal display panel 59; a backlight unit 49; and bezels BZ (front bezel and rear bezel) that sandwich and hold the liquid crystal display panel 59 and the backlight unit 49.

The liquid crystal display panel 59 attaches an active matrix board 51 that includes switching elements such as a TFT (Thin Film Transistor) and the like, and an opposite board 52 that faces the active matrix board 51 to each other by means of a seal member (not shown). And, liquid crystal (not shown) is injected into a gap between both boards 51, 52 (here, polarization films 53, 53 are so disposed as to sandwich the active matrix board 51 and the opposite board 52).

Besides, an FPC (Flexible Printed Circuits) board 11 that has flexibility is disposed on an outer edge of the active matrix board 55 in the liquid crystal display device 59. In detail, the FPC board (circuit board) 11 is a board that includes a supply wiring (not shown) that flows an electric current from a not-shown power supply; and is connected to the liquid crystal display panel 59. And, the supply wiring of the FPC board 11 is connected, for example, to a driver (not shown) that controls display of the liquid crystal display panel 59. Besides, on a board surface of the FPC board 11 that is in contact with the liquid crystal display panel 59, an LED (Light Emitting Diode) 41 is disposed.

Here, the FPC board 11 includes a ground pattern 12 that is able to conduct electricity (here, a ground line is omitted). In detail, the ground pattern 12 is formed on a board surface of a rear side of the board surface of the FPC 11 that is in contact with the liquid crystal display panel 59 (in short, the LED 41 and the ground pattern 12 are not present on the same board surface).

The backlight unit 49 shines light onto the non-light-emitting liquid crystal display panel 59. In other words, the liquid crystal display panel 59 receives the light (backlight) from the backlight unit 49, thereby performing a display function. Because of this, if the light from the backlight unit 49 is able to be evenly shined onto the entire surface of the liquid crystal display panel 59, the display quality of the liquid crystal display panel 59 improves.

And, the backlight unit 49, as shown in Fig. 1 and Fig. 2, includes: the LED 41 ; a light guide plate 42; a reflection sheet 43; a diffusion sheet 44; optical sheets 45, 46; and a built-in chassis CS.

The LED 41 is a light source and disposed on an electrode (not shown) formed on the FPC board 11 that is disposed on the liquid crystal display panel 59 thereby being supplied with an electric current to emit light. Here, to secure an amount of light, it is desirable that a plurality of the LEDs (light-emitting diode, point light source) 41 are disposed and arranged in a line on the FPC board 11. However, in the figure, for convenience, only part of the LED 41 is shown (incidentally, hereinafter, the arrangement direction is called an arrangement direction P).

The light guide plate 42 is a plate-shape member that has: a side surface 42S; a top surface 42U and a bottom surface 42B which are so situated as to sandwich the side surface 42S. And, a surface (light receiving surface) of the side surface 42S faces the light-emitting surface of the LED 41, thereby receiving the light from the LED 41. The received light undergoes multiple reflection in the inside of the light guide plate 42 and goes out as area light from the top surface 42U to outside.

The reflection sheet 43 is so situated as to be covered by the light guide plate 42. And, a surface of the reflection sheet 43 that faces the bottom surface 42B of the light guide plate 42 serves as a reflection surface. Because of this, the reflection surface reflects the light from the LED 41 and the light traveling in the inside of the light guide plate 42 back into the light guide plate 42 without leaking both light (in detail, via the bottom surface 42B of the light guide plate 42).

The diffusion sheet 44 is so situated as to cover the top surface 42U of the light guide plate 42 and diffuses the area light from the light guide plate 42, thereby spreading the light to the entire region of the liquid crystal display panel 59 (here, the diffusion sheet 44 and the optical sheets 45, 46 are also collectively called an optical sheet group).

The optical sheets 45 has, for example, a prism shape in the sheet surface; narrows the light directivity; and is so situated as to cover the diffusion sheet 44. Because of this, the optical sheet 45 collets the light traveling from the diffusion sheet 44 to improve the brightness.

The optical sheet 46 is so situated as to cover the optical sheet 45; allows a polarized-light component in a direction to pass through, while reflecting a polarized-light component in a direction perpendicular to the passing-through polarized light component. And, the optical sheet 46 reflects and reuses a polarized-light component that is absorbed by a polarization film 53, thereby improving the brightness of the liquid crystal display panel 59.

The built-in chassis CS is a frame-shape base that encloses and holds the above various members. In detail, the built-in chassis CS stacks up and holds the reflection sheet 43; the light guide plate 42; the diffusion sheet 44; the optical sheets 45, 46 in this order (here, the stack-up direction is called a stack-up direction Q, while a direction (e.g., perpendicular direction) intersecting the arrangement direction P and the stack-up direction Q is called an intersection direction R).

And, in the above backlight unit 49, the light from the LED 41 goes out from the top surface 42U as the area light due to the multiple reflection in the inside of the light guide plate 42; the area light passes through the optical sheet group (44 to 46), thereby going out as the backlight whose brightness is improved. And, the backlight reaches the liquid crystal display panel 59, so that the liquid crystal display panel 59 displays an image by means of the backlight.

The front bezel BZ1 is a frame body that has: a frame piece 31; and a side wall WL (outside wall WL1) that goes up from an outer edge of the frame piece 31. Here, the material of the front bezel BZ1 is not especially limited; and may be a resin or a metal.

The rear bezel BZ2 is a box body that has: a bottom surface 33; and a side wall WL (inside wall WL2) that goes up from an outer edge of the bottom surface 33. And, the rear bezel BZ2 is formed of an electro-conductive material (e.g., metal). However, if it is an electro-conductive material, the kind of the metal is not especially limited.

And, the rear bezel BZ2 houses the backlight unit 49; and the built-in chassis CS of the backlight unit 49 supports the liquid crystal display panel 59. In detail, a frame piece CSf of the built-in chassis CS supports the active matrix board 51, so that the built-in chassis CS holds the liquid crystal display panel 59.

Here, in the case where the built-in chassis CS in the rear bezel BZ2 supports the liquid crystal display panel 59, the FPC board 11 disposed on the active matrix board 51, as shown in Fig. 1, so bends (clings) as to cover the frame piece CSf of the built-in chassis CS, thereby situating the LED 41 on the side surface 42S of the light guide plate 42. Accordingly, between the built-in chassis CS and the rear bezel BZ2, the FPC board 11 is present (here, the package in which the built-in chassis CS and the FPC board 11 are disposed in the rear bezel BZ2 that is the housing is also called an electronic package PG).

And, the front bezel BZ1 covers the rear bezel BZ2, which houses the backlight unit 49, and serves as a lid for the rear bezel BZ2. According to this, the rear bezel BZ2 and the front bezel BZ1 house the backlight unit 49 and the liquid crystal display panel 59 (here, it is possible to call both bezels BZ1, BZ2 a housing because the bezels BZ1, BZ2 house the liquid crystal display panel 59 and the backlight unit 49).

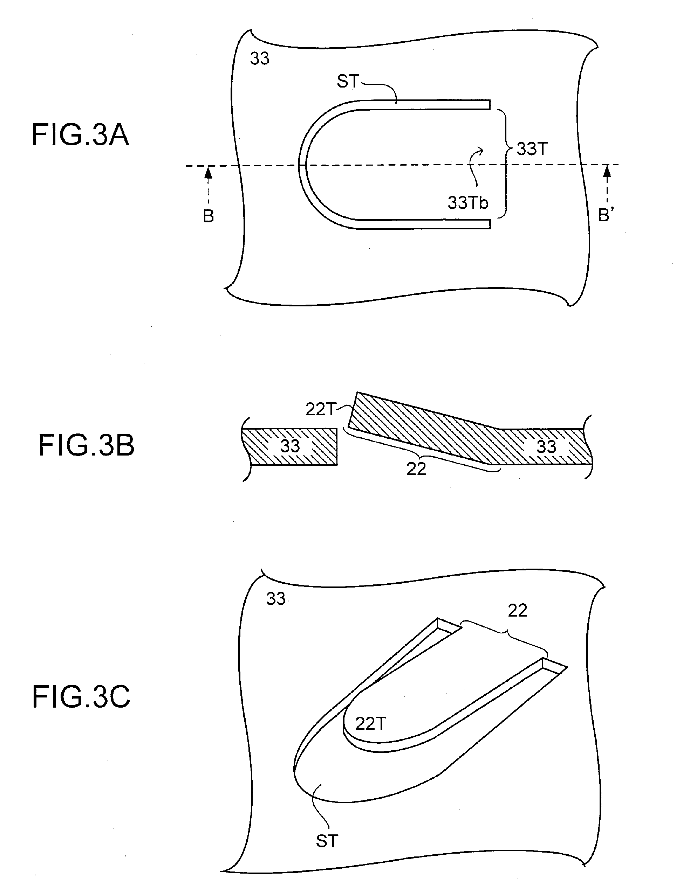

Here, by means of Fig. 3A to Fig. 3C besides Fig. 1 and Fig. 2, it is described how the ground pattern 12 of the FPC board 11 secures the conduction (in other words, a connection structure between the ground pattern 12 and a conductive portion is described). Here, Fig. 3A is a plan view showing the bottom surface 33 of the rear bezel BZ2; Fig. 3B is a sectional view taken along and viewed from an arrow B-B' line of Fig. 3A; and Fig. 3C is a perspective view showing the bottom surface 33 of the rear bezel BZ2.

First, the rear bezel BZ2 that faces the ground pattern 12 is described. The rear bezel BZ2, as shown in Fig. 3A, includes a claw portion (conductive portion) 22 that is formed by means of a parenthesis-shape (e.g., U shape) cut ST disposed through the bottom surface 33. In detail, with respect to a stem portion 33Tb of a tongue piece 33T that occurs from the cut ST, the tongue piece 33T warps up (rises) from the rear bezel BZ2 toward the front bezel BZ1, so that the claw portion 22 is completed (see Fig. 3B and Fig. 3C; here, it is also possible to say that the claw portion 22 is the same as the tongue piece 33T).

And, the position of the claw portion 22, as shown in Fig. 1, faces the ground pattern 12 of the FPC board 11 that bends to cling to the frame piece CSf of the built-in chassis CS. In detail, on part of the FPC board 11 that clings to the frame piece CSf, especially on part of the FPC board 11 that lies on a surface of the frame piece CSf which faces toward the rear bezel BZ2, the ground pattern 12 is formed and the position of the claw portion 22 is decided to match the position of the ground pattern 12.

And, the claw portion 22 is formed of a metal that is the material of the rear bezel BZ2 and warps up with respect to the bottom surface 33 of the rear bezel BZ2. Because of this, when the FPC board 11 comes close to the bottom surface 33 of the rear bezel BZ2, the ground pattern 12 of the FPC board 11 is situated between the frame piece CSf of the built-in chassis CS and the claw portion 22, and touches the claw portion 22.

According to this, the ground pattern 12 is sandwiched between the two members (built-in chassis CS and rear bezel BZ2), so that the ground pattern 12 becomes unlikely to excessively deviate and surely touches the claw portion 22. Because of this, static electricity flows to the rear bezel BZ2 via the ground pattern 12, so that various disadvantages due to the static electricity do not occur in the various circuits in the liquid crystal display device 69 (the liquid crystal display device 69 to which so-called ESD (Electro Static Discharge) measures are applied is completed). Moreover, the various circuits in the liquid crystal display device 69 are not influenced by the static electricity, so that it is also possible to say that the liquid crystal display device 69 has EMC (Electro Magnetic Compatibility).

Besides, the claw portion 22 is a linear metal piece that warps up from the bottom surface 33 of the rear bezel BZ2. Because of this, when the claw portion 22 is pushed against the bottom surface 33, the claw portion 22 generates restoration force that tries to return to the original state (in short, the claw portion 22 has elasticity).

Accordingly, when the FPC board 11 comes close to the bottom surface 33 of the rear bezel BZ2 until the ground pattern 12 pushes the claw portion 22, the claw potion (push piece) 22 counters the push force to push the ground pattern 12 against the built-in chassis CS, thereby firmly touching the ground pattern 12 (in short, the ground pattern 12 touches the built-in chassis CS and the claw portion 22 while being sandwiched, so that the ground pattern 12 and the claw portion 22 firmly touch each other). Because of this, the static electricity surely escapes to the rear bezel BZ2 via the ground pattern 12.

Besides, the tip end 22T of the claw portion 22, as shown in Fig. 3A and Fig. 3C, has a semicircle shape. In other words, the claw portion 22 has the tip end 22T whose outer edge is rounded. And, the rounded tip end 22T pushes the ground pattern 12 toward the frame piece CSf of the built-in chassis CS. Because of this, even if the claw portion 22 firmly pushes the ground pattern 12, the ground pattern 12 is not broken.

Besides, the claw portion 22 pushes the ground pattern 12 against the built-in chassis CS, so that the claw portion 22 does not excessively warp up with respect to the bottom surface 33 of the rear bezel BZ2. Accordingly, problems that the claw potion 22 causes because of an excessive warpage of the claw portion 22, for example, such troubles that a user is injured by the claw portion 22, and the claw portion 22 is ripped off to fall from the rear bezel BZ2 become unlikely to happen.

### [Embodiment 2]

An embodiment 2 is described. Here, members that have the same functions as those of the members which are used in the embodiment 1 are indicated by the same reference numbers and description of them is skipped.

In the liquid crystal display device 69 according to the embodiment 1, part of the rear bezel BZ2, which faces the ground pattern 12, is the claw portion 22. And, the claw portion 22 is formed by the cut ST disposed through the rear bezel BZ2. However, the conductive portion that touches the ground pattern 12 is not limited to the claw portion 22.

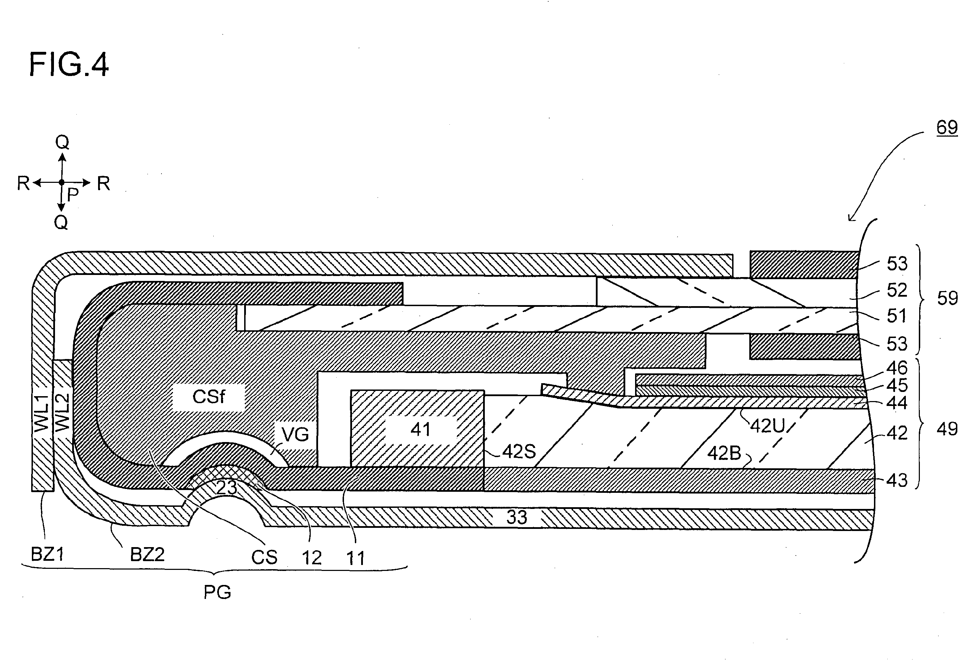

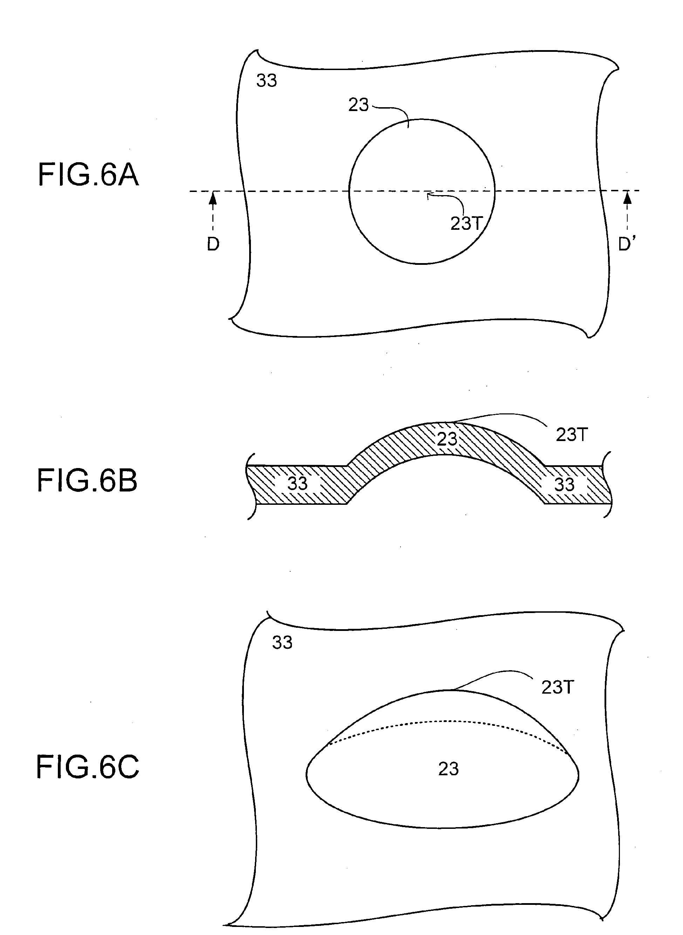

Hereinafter, in the embodiment 2, another example of the claw portion 22 that is the conduction portion is described by means of Fig. 4, Fig. 5, and Fig. 6A to Fig. 6C. Here, Fig. 4, Fig. 5 and Fig. 6A to Fig. 6C are shown in similar ways to Fig. 1, Fig. 2 and Fig. 3A to Fig. 3C, respectively.

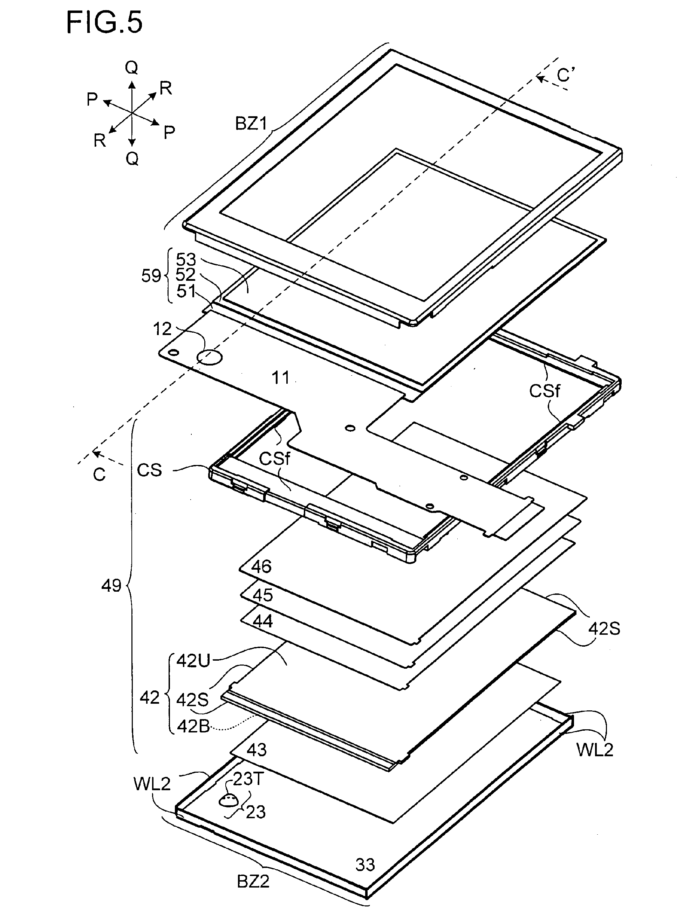

As shown in Fig. 4 and Fig. 5, the rear bezel BZ2 is provided with a semispherical (curved-surface) swell portion (push piece) 23 that swells from the bottom surface 33 toward the front bezel BZ1 side. And, the swell portion 23, like the claw portion 22, faces the ground pattern 12 of the FPC board 11 that bends to cling to the frame piece CSf of the built-in chassis CS (see Fig. 4).

Because of this, when the FPC board 11 comes close to the bottom surface 33 of the rear bezel BZ2, the ground pattern 12 of the FPC board 11 is situated between the frame piece CSf of the built-in chassis CS and the swell portion 23, and touches the swell portion 23.

Accordingly, even such swell potion 23 brings the same effects as those the claw portion 22. In other words, in the liquid crystal display device 69, static electricity flows to the rear bezel BZ2 via the ground pattern 12, so that various disadvantages due to the static electricity do not happen.

Besides, the swell portion 23 swells from the bottom surface 33 (a surface) of the rear bezel BZ2, while a tip end of the swelling is formed into a curved surface. Because of this, the tip end 23T of the curved surface pushes the ground pattern 12 toward the frame piece CSf of the built-in chassis CS. Accordingly, even if the swell portion 23 firmly pushes the ground pattern 12, the ground pattern 12 is not broken.

Here, the swell portion 23 is relatively small and has a grain shape, so that the swell potion 23 has relatively small elasticity compared with the claw portion 22 (in short, the swell portion 23 has almost no elasticity). Because of this, the position of another member (e.g., built-in chassis CS) that touches the swell portion 23 directly or indirectly is likely to deviate.

However, in a case where the rear bezel BZ2 including such swell portion 23 is employed in the liquid crystal display device 69, as shown in Fig. 4, in light of the shape of the swell portion 23, a recess VG may be formed in the built-in chassis CS. In other words, the recess VG, which is able to house at least part of the swell portion 23 and part of the ground pattern 12 that touches the swell portion 23 (and part of the FPC board 11 on which the ground patter 12 lies), may be formed in the built-in chassis CS

According to this, in the liquid crystal display device 69, the built-in chassis CS does not touch the swell portion 23 and does not deviate. Because of this, a disadvantage caused by deviation of the built-in chassis CS, for example, a positional deviation of the liquid crystal display panel 59 with respect to the backlight unit 49 does not happen, so that the image quality of the liquid crystal display panel 59 is kept.

However, such recess VG of the built-in chassis CS is not a must. Because, even if there is not the recess VG, if the swell potion 23 has a grain shape and does not have such a size that deviates the built-in chassis CS and the like, the recess VG is unnecessary.

In the case where there is not the recess VG, like the claw portion 22, when the FPC board 11 comes close to the bottom surface 33 of the rear bezel BZ2, the ground pattern 12 touches the built-in chassis CS and the swell portion 23 while being sandwiched. Accordingly, the ground pattern 12 and the swell portion 23 firmly touch each other. In this case, the static electricity surely escapes to the rear bezel BZ2 via the ground pattern 12.

Besides, the swell portion 23, unlike the claw portion 22, is not formed by the cut ST disposed through the rear bezel BZ2. Because of this, as for the rear bezel BZ2 including the swell portion 23, foreign matter such as dust and the like does not invade the inside of the liquid crystal display device 69 via an opening like the cut ST.

### [Other Embodiments]

Here, the present invention is not limited to the above embodiments; and various modifications are possible without departing from the spirit of the present invention.

For example, it is desirable that in the liquid crystal display device 69, the material of the front bezel BZ1 is also an electro-conductive material like the rear bezel BZ2. The reason is that because the rear bezel BZ2 and the front bezel BZ1 touch each other, static electricity escapes more easily via the electro-conductive portion such as the claw portion 22 (and the swell portion 23).

Besides, in the above description, The LED 41 is described as the light source; however, this is not limiting. For example, light-emitting elements, which are composed of self-light-emitting materials such as a fluorescent lamp like a cold cathode fluorescent lamp, an organic EL (Electro-Luminescence) and the like, may be employed as the light source.

Lastly, it is possible to say that electronic apparatuses which incorporate a display device such as the above liquid crystal display device 69 and the like, for example, a notebook-sized personal computer, a mobile phone, a PDA (Personal Digital Assistant) are also the present invention.

### Reference Signs List

11 FPC board (circuit board)
12 ground pattern
22 claw portion (push piece)
22T tip end of the claw portion
23 swell portion (push piece)
23T tip end of the swell portion
BZ1 front bezel (housing)
BZ2 rear bezel (housing)
33 bottom surface of the rear bezel
ST cut disposed through the bottom surface of the rear bezel
33T tongue piece
33Tb stem potion of the tongue piece
41 LED
42 light guide plate
43 reflection sheet
44 diffusion sheet
45 optical sheet
46 optical sheet
CS built-in chassis (chassis)
CSf frame piece (chassis) of the built-in chassis
49 backlight unit
59 liquid crystal display panel
69 liquid crystal display device (display device)

## Claims

1. An electronic package in which a chassis and a circuit board including a ground pattern are disposed in a housing, wherein
the ground pattern is present between the housing and the chassis;
the housing includes a push piece that pushes the ground pattern against the chassis; and
the push piece has elasticity in a linear state and pushes the ground pattern by means of a tip end whose outer edge is rounded.

2. An electronic package in which a chassis and a circuit board including a ground pattern are disposed in a housing, wherein
the ground pattern is present between the housing and the chassis;
the housing includes a push piece that pushes the ground pattern against the chassis; and
the push piece swells from a surface of the housing, a tip end of the swelling is formed into a curved surface, and the tip end pushes the ground pattern.

3. A display device incorporating the electronic package according to claim 1 or 2.

4. An electronic apparatus incorporating the display device according to claim 3.
